# EUROPÄISCHE PATENTANMELDUNG

(11) **EP 3 806 335 A1**
(43) Veröffentlichungstag der Anmeldung: **14.04.2021**
(21) Anmeldenummer: 20199748.3
(22) Anmeldetag: 02.10.2020
(51) Int. Cl.: H03K 17/96

(54) **BAUTEIL FÜR EIN KAPAZITIVES BEDIENELEMENT, KAPAZITIVES BEDIENELEMENT UND HAUSHALTSGERÄT**

(30) Priorität: 09.10.2019 DE 102019215461
(71) Anmelder: BSH Hausgeräte GmbH, 81739 München (DE)
(72) Erfinder: Bayer, Andreas, 94336 Hunderdorf (DE); Duscher, Christian, 93152 Nittendorf (DE); Schemmerer, Roman, 84088 Neufahrn i. NB (DE)

(57) **Zusammenfassung**

Offenbart ist ein Bauelement 10, 20, 30, 40 zur Anordnung zwischen einer Blende 100 und einer Leiterplatte 200 eines kapazitives Bedienelements 1. Das Bauteil umfasst eine elastische Silikonschicht 11, 21, 31, 41 und ein daran angeordnetes elektrisch leitfähiges Material 12, 22, 32, 42, das dazu eingerichtet ist, die Blende 100 des kapazitiven Bedienelements funktionell an dessen Leiterplatte 200 anzubinden.

Offenbart ist weiterhin ein kapazitives Bedienelement mit einer Blende 100, einer Leiterplatte 200 und einem dazwischen in Kontakt zu beiden angeordneten oder anzuordnenden Bauteil 10, 20, 30, 40. Weiterhin offenbart ist ein Haushaltsgerät mit mindestens einem derartigen kapazitiven Bedienelement 1.

## Beschreibung

Die vorliegende Erfindung betrifft ein Bauteil für ein kapazitives Bedienelement. Darüber hinaus betrifft die Erfindung ein kapazitives Bedienelement mit einem solchen Bauteil sowie ein Haushaltsgerät mit einem derartigen kapazitiven Bedienelement.

Aus dem Stand der Technik sind kapazitive Bedienelemente (auch unter der Bezeichnung "kapazitive Touch-Elemente") bekannt. Sie umfassen ein Bedienfeld, das zur Vermeidung von Verschmutzungen häufig in eine (starre) Blende integriert ist, eine Leiterplatte und mindestens ein dazwischen angeordnetes Bauteil, das ein elektrisch leitfähiges Material umfasst.

Über das elektrisch leitfähige Material verbindet das Bauteil die Leiterplatte so mit einer geeignet kleinen Umgebung der Blende, dass ein Kontakt oder auch nur eine unmittelbare Nähe eines menschlichen Fingers mit/zu der Blende eine Kapazitätsänderung in der Leiterplatte bewirkt. Das elektrisch leitfähige Material ermöglicht mit dieser Verbindung somit die Funktion des kapazitiven Bedienelements. Dies wird im Folgenden als "funktionelles Anbinden" der Blende an die Leiterplatte bezeichnet. Die Realisierung derartiger funktioneller Anbindungen einschließlich dafür nötiger Abstände und Bedingungen an die Umgebung der Blende ist aus dem Stand der Technik bekannt und wird daher in dieser Schrift nicht thematisiert.

Damit ein derartiges funktionelles Anbinden gewährleistet ist, muss das besagte Bauteil zu einem jeweiligen Abstand von Blende und Leiterplatte passen. Da nun dieser Abstand bei kapazitativen Bedienelementen montage- und fertigungsbedingten Schwankungen unterliegt, sind Bauteile bekannt, die ein elektrisch leitfähiges, komprimierbares Federelement umfassen. Damit können Abstandsabweichungen innerhalb eines Toleranzbereichs ausgeglichen und gleichwohl ein sicheres funktionelles Anbinden erreicht werden.

Der vorliegenden Erfindung liegt die Aufgabe zugrunde, eine Technik bereitzustellen, die eine vereinfachte Herstellung kapazitiver Bedienelemente ermöglicht. Der Erfindung liegen weiterhin die Aufgaben zugrunde, ein vereinfacht herzustellendes Bedienelement und ein vereinfacht herzustellendes Haushaltsgerät bereitzustellen.

Die Aufgaben werden gelöst durch ein Bauteil gemäß Anspruch 1, ein Bedienelement nach Anspruch 7 und ein Haushaltsgerät nach Anspruch 10. Vorteilhafte Ausführungsformen sind in den Unteransprüchen, der Beschreibung und den Figuren offenbart.

Ein erfindungsgemäßes Bauteil ist zur Verwendung in einem (passenden) kapazitiven Bedienelement (beispielsweise für ein Haushaltsgerät) vorgesehen. Es umfasst mindestens eine elastische Silikonschicht sowie ein daran angeordnetes elektrisch leitfähiges Material, das dazu eingerichtet (geeignet) ist, eine Blende des kapazitiven Bedienelements funktionell an dessen Leiterplatte anzubinden.

Die mindestens eine elastische Silikonschicht ermöglicht dabei, dass Abstandsungenauigkeiten von Blende und Leiterplatte auf einfache Weise ausgeglichen werden können. Das Bauteil wird damit flexibler verwendbar. Zudem wird eine die Herstellung des Bedienelements vereinfacht, indem ein erhöhter Aufwand zur präzisen Einhaltung vorgegebener Abstände sowie Einpassarbeiten am Bauteil vermieden und gleichwohl eine sichere funktionelle Anbindung gewährleistet werden kann. Die Elastizität des Bauteils wird dabei durch die Silikonschicht erreicht, die einfach herzustellen und bequem zu handhaben ist. Dabei ist das Silikon hitzebeständig und abdichtend, was einen breiten Einsatzbereich des Bauteils ermöglicht.

Insbesondere kann die Silikonschicht als ein Formteil ausgebildet sein, das beispielsweise durch Spritzguss auf einfache Weise gefertigt sein kann. Die Silikonschicht kann beispielsweise eine gleichmäßige oder mittlere Dicke (Stärke) aufweisen, die höchstens 3mm, höchstens 2mm, höchstens 1mm oder höchstens 0,5mm beträgt.

Ein erfindungsgemäßes Bedienelement umfasst eine Blende, eine Leiterplatte und ein dazwischen in Kontakt mit beiden angeordnetes oder anzuordnendes erfindungsgemäßes Bauteil nach einer der in dieser Schrift offenbarten Ausführungsformen.

Ein erfindungsgemäßes Haushaltsgerät weist ein erfindungsgemäßes kapazitives Bedienelement gemäß einer der in dieser Schrift offenbarten Ausführungsformen auf. Es kann insbesondere ein Haushaltskleingerät (beispielsweise ein Kaffeeautomat, eine Küchenmaschine, ein Bügeleisen, ein Staubsauger oder ein Durchlauferhitzer) sein oder ein Haushaltsgroßgerät (wie etwa eine Wasch- oder Spülmaschine, ein Kühlschrank oder ein Herd).

Gemäß vorteilhaften Ausführungsformen bildet ein erfindungsgemäßes Bauteil eine Grundfläche sowie mindestens eine von der Grundfläche abstehende Überbrückungsstruktur aus, die dazu eingerichtet ist, einen Abstand zwischen der Leiterplatte und der Blende eines kapazitiven Bedienelements (für das das Bauteil vorgesehen ist) zu überbrücken. Eine derartige Überbrückungsstruktur kann beispielsweise quader- bzw. tastenartig oder als Kuppel ausgebildet sein. Sie kann die Elastizität des Bauteils verbessern und/oder jeweilige Flächenbereiche der Blende abgrenzen, die bei Berührung eine Funktion aufweisen.

Die mindestens eine Überbrückungsstruktur kann bei derartigen Ausführungsformen durch die mindestens eine Silikonschicht ausgebildet sein und/oder durch das elektrisch leitfähige Material, beispielsweise als dreidimensionale Struktur aus einem elektrisch leitfähigen Silikon. Vorzugsweise ist die mindestens eine Überbrückungsstruktur elastisch in Richtung zur Grundfläche hin. Dazu kann sie insbesondere Bereiche voneinander verschiedener Materialstärke aufweisen und/oder balgartig geformt sein (insbesondere mindestens eine Wölbung und/oder Falte in Richtung parallel zur Grundfläche aufweisen).

Gemäß vorteilhaften Ausführungsformen ist ein erfindungsgemäßes Bauteil mindestens bereichsweise lichtdurchlässig. Es kann beispielsweise mindestens einen Lichtdurchlass in Form eines (jeweiligen) Symbols aufweisen. In einem erfindungsgemäßen kapazitiven Bedienelement kann ein derartiges Symbol auf oder über einem an der Leiterplatte angeordneten (und vorzugsweise angeschlossenen) Leuchtelement wie beispielsweise einer LED angeordnet sein oder werden. So kann eine funktionelle Bedeutung des kapazitiven Bedienelements im jeweiligen Bereich gekennzeichnet, also symbolisiert werden, was eine Berührung der Blende in dem jeweiligen lichtdurchlässigen Bereich bewirkt. Zugleich erlaubt die Integration dieser Kennzeichnung eine besonders platzsparende Ausbildung des kapazitiven Bedienelements. Schließlich sind die Lichtsymbole im ausgeschalteten Zustand vorzugsweise mindestens weitgehend unsichtbar, so dass das Bedienfeld dann vorteilhaft unauffällig ist.

In Ausführungsformen mit mindestens einer Überbrückungsstruktur wie oben erwähnt kann diese vorzugsweise eine Kammer ausbilden, die an einer der Leiterplatte zuzuwendenden Seite hin offen ist. Eine derartige Überbrückungsstruktur eignet sich dazu, über ein an der Leiterplatte angeordnetes Leuchtelement gestülpt zu werden. Vorzugsweise weist die Überbrückungsstruktur dann mindestens einen lichtdurchlässigen Bereich (z.B. in Form eines Symbols auf), beispielsweise in einer der Blende zuzuwendenden Deckfläche.

Ein kapazitives Bedienelement gemäß einer vorteilhaften Ausführungsform umfasst ein mit einer oder mehreren solchen Überbrückungsstruktur/en ausgebildetes Bauteil, die über ein jeweiliges an der Leiterplatte angeordnetes (und vorzugsweise angeschlossenes) Leuchtelements gestülpt sind. Im Falle mehrerer Überbrückungsstrukturen weisen diese vorzugsweise voneinander verschiedene Symbole auf, die jeweils eine funktionelle Bedeutung des kapazitiven Bedienelements im jeweiligen Bereich kennzeichnen.

Die elastische Silikonschicht eines erfindungsgemäßen Bauteils ist vorzugsweise transparent. Sie kann mindestens bereichsweise (insbesondere mit Ausnahme eines Symbols wie oben erwähnt) mit einer lichtundurchlässigen Schicht, insbesondere einem lichtdichten Lack überzogen sein. Dadurch wird die Silikonschicht unter der Blende besonders unauffällig.

Das elektrisch leitfähige Material kann eine dreidimensionale Struktur aus einem elektrisch leitfähigen Material, insbesondere aus leitfähigem Silikon umfassen; eine derartige dreidimensionale Struktur kann insbesondere eine Überbrückungsstruktur wie oben erwähnt ausbilden.

Alternativ oder zusätzlich kann das elektrisch leitfähige Material eine elektrisch leitfähige Farbe umfassen. Diese kann mindestens bereichsweise auf eine Oberfläche, insbesondere eine der Leiterplatte zuzuwendende oder zugewandte Oberfläche der Silikonschicht aufgebracht, beispielsweise aufgespritzt sein. Schließlich kann das elektrisch leitfähige Material (alternativ oder zusätzlich) eine leitfähige Silikonschicht umfassen.

In den oben genannten Ausführungsformen mit mindestens einem lichtdurchlässigen Bereich kann das leitfähige Material eine jeweilige Aussparung ausbilden, beispielsweise in Form eines Symbols zur Kennzeichnung, was eine Berührung des jeweiligen Bereichs bewirkt. Ein derartiges Symbol kann beispielsweise eingelasert oder durch Maskierung erzeugt sein.

Gemäß vorteilhaften Ausführungsformen ist die Silikonschicht eines erfindungsgemäßen Bauteils dazu eingerichtet, die Leiterplatte des kapazitiven Bedienelements ganz oder teilweise abzudecken.
Das Bauteil wirkt damit abdichtend, beispielsweise gegen Luftfeuchtigkeit oder in einer feuchten Umgebung, und schützt so die Leiterplatte. Die Leiterplatte eines erfindungsgemäßen Bedienelements kann analog ganz oder teilweise durch die Silikonschicht des erfindungsgemäßen Bauteils abgedeckt sein.

Insbesondere kann die Silikonschicht dabei als Matte geformt sein, in oder an der mehrere Überbrückungsstrukturen wie oben erwähnt ausgebildet sind und die die Leiterplatte ganz oder teilweise abdeckt. Bei einem erfindungsgemäßen kapazitiven Bedienelement mit solch einem Bauteil können mindestens zwei der Überbrückungsstrukturen dann über voneinander verschiedene Leuchtelemente gestülpt oder zu stülpen sein. Auf diese Weise können mit ihnen verschiedene Betätigungsfelder markiert sein.

Derartige Ausführungsformen eigenen sich besonders zur Verwendung beispielsweise in einer Wasch- oder Spülmaschine, einem Wäschetrockner oder einer Küchenmaschine.

Im Folgenden werden bevorzugte Ausführungsbeispiele der Erfindung anhand von Zeichnungen näher erläutert. Es versteht sich, dass einzelne Merkmale auch anders kombiniert werden können als dargestellt, sowie dass reale Größenverhältnisse von den dargestellten abweichen können.

Es zeigen schematisch:
- Figur 1:: einen Bereich eines exemplarischen erfindungsgemäßen kapazitiven Bedienelements mit einer ersten exemplarische Ausführungsform eines erfindungsgemäßen Bauteils in einer Schnittdarstellung;
- Figur 2:: eine zweite exemplarische Ausführungsform eines erfindungsgemäßen Bauteils in einer Schnittdarstellung;
- Figur 3:: eine dritte exemplarische Ausführungsform eines erfindungsgemäßen Bauteils in einer Schnittdarstellung;
- Figur 4a:: eine vierte exemplarische Ausführungsform eines erfindungsgemäßen Bauteils in perspektivischer Ansicht; und
- Figur 4b:: die vierte exemplarische Ausführungsform eines erfindungsgemäßen Bauteils in einer Schnittdarstellung.

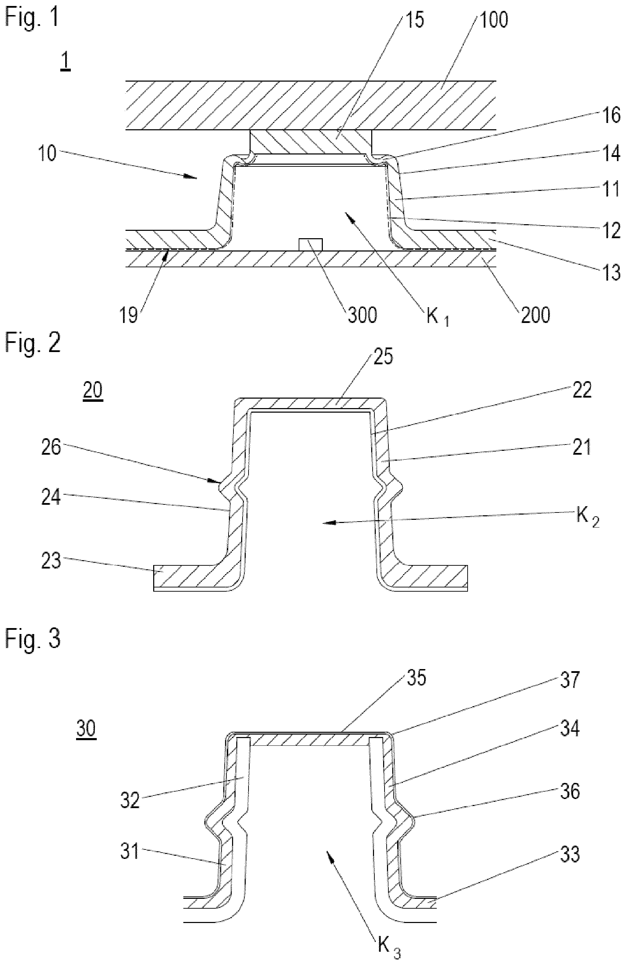

In Figur 1 ist in einem Querschnitt ein Ausführungsbeispiel eines erfindungsgemäßen kapazitiven Bedienelements 1 dargestellt. Es umfasst ein erfindungsgemäßes Bauteil 10, sowie eine vorzugsweise starre Blende 100 und eine Leiterplatte 200, zwischen denen das Bauteil 10 in Kontakt zu beiden angeordnet ist. Die Blende 100 ist vorzugsweise transparent oder semitransparent. Sie kann beispielsweise mindestens teilweise aus Glas und/oder Kunststoff bestehen.

Das Bauteil 10 umfasst eine elastische Silikonschicht 11 und ein elektrisch leitfähiges Material 12, das vorliegend als eine leitfähige Farbe auf einer der Leiterplatte zugewandten Seite der Silikonschicht 11 ausgebildet ist. Das elektrisch leitende Material 12 erstreckt sich von einem Kontaktbereich 19, in dem es an der Leiterplatte 200 anliegt, bis in eine geeignet kleine Umgebung der Blende 100, die es damit funktionell an die Leiterplatte anbindet.

Das Bauteil 10 weist eine Grundfläche 13 auf, von der eine Überbrückungsstruktur 14 absteht. Die Überbrückungsstruktur wird vorliegend insbesondere durch die elastische Silikonschicht ausgebildet und erstreckt sich bis zur Blende 100, an der sie mit einer Deckfläche 15 anliegt. In einem ringförmigen Bereich 16 bildet sie Welle aus und weist dort im Vergleich zu einem umgebenden Bereich eine reduzierte Materialstärke auf. Dadurch wird die (bereits aus dem elastischen Silikonmaterial resultierende) Elastizität der Überbrückungsstruktur in Richtung zur Grundfläche 13 hin noch erheblich verstärkt. Insbesondere konnte das Bauteil 10 daher auch dann problemlos funktionell anbindend zwischen der Blende 100 und der Leiterplatte 200 angeordnet werden, wenn deren Abstand nicht präzise einer Sollgröße entsprach.

Die Überbrückungsstruktur bildet eine Kammer K₁ aus, die an der der Leiterplatte 200 zugewandten Seite offen ist. So konnte die Überbrückungsstruktur 14 über ein an der Leiterplatte angeordnetes und vorzugsweise angeschlossenes Leuchtelement 300 (z.B. in Form einer LED) gestülpt werden. Dabei ist das Leuchtelement 300 von der Deckfläche 15 beabstandet, so dass Licht die ganze Deckfläche erreichen kann (nicht dargestellt). Vorzugsweise weist die Deckfläche 15 einen lichtdurchlässigen Bereich auf, in dem insbesondere ein Symbol ausgebildet sein kann. Dazu kann das elektrisch leitfähige, lichtundurchlässige Material eine entsprechende Aussparung aufweisen. Mittels des Symbols kann einem Anwender kenntlich gemacht werden, was eine Betätigung des Bedienelements durch Berührung der Blende im Bereich der Überbrückungsstruktur bewirkt.

Insbesondere kann das kapazitive Bedienelement 1 mindestens eine weitere (nicht dargestellte Überbrückungsstruktur) aufweisen, die ebenfalls von der Grundfläche 13 absteht, vorzugsweise ebenfalls eine zur Leiterplatte hin offene Kammer ausbildet und vorzugsweise ebenfalls über ein an der Leiterplatte 200 angeordnetes und angeschlossenes Leuchtelement gestülpt ist. Auch dessen Deckfläche weist dann vorzugsweise einen lichtdurchlässigen Bereich mit einem Symbol auf; dieses ist dann vorzugsweise vom Symbol an der Deckfläche 15 verschieden, so dass unterschiedliche Wirkungen der Berührung der Blende 100 im jeweiligen Bereich gekennzeichnet sind.

Die Figur 2 zeigt in einer Schnittdarstellung ein Bauteil 20 gemäß einer weiteren Ausführungsform der vorliegenden Erfindung. Das Bauteil 20 umfasst eine elastische Silikonschicht 21, an der wie beim oben beschriebenen Bauteil 10 ein elektrisch leitfähiges Material 22 in Form einer leitfähigen Farbe aufgebracht ist. Bei Anordnung des Bauteils zwischen und jeweils im Kontakt zu einer Leiterplatte und einer Blende bindet das elektrisch leitfähige Material 22 die Blende funktionell an die Leiterplatte an.

Das Bauteil 20 bildet eine Grundfläche 23 aus, von der eine Überbrückungsstruktur 24 absteht. Die Grundfläche 23 ist dazu vorgesehen, bei einer Verwendung des Bauteils 20 in einem erfindungsgemäßen kapazitiven Bedienelement auf dessen Leiterplatte aufzuliegen. Die Überbrückungsstruktur 24 bildet eine Kammer K₂ aus, die an dieser Seite offen ist und damit analog zum Obigen über ein ggf. an der Leiterplatte angeordnetes Leuchtelement gestülpt werden kann. An der entgegengesetzten Deckfläche 25 ist das Bauteil 20 vorzugsweise mindestens bereichsweise transparent. Insbesondere weist das elektrisch leitfähige Material dort vorzugsweise eine entsprechende Aussparung auf.

In Richtung zur Grundfläche 23 hin ist die Überbrückungsstruktur 24 elastisch ist. Die dem elastischen Silikonmaterial eigene Elastizität wird dabei vorliegend durch eine balgartige Auswölbung 26 bzw. Faltung verstärkt.

In Figur 3 ist mit einer Schnittdarstellung ein weiteres Ausführungsbeispiel eines erfindungsgemäßen Bauteils 30 gezeigt. Dieses umfasst eine elastische Silikonschicht 31, an der ein elektrisch leitfähiges Material 32 angeordnet ist, das dazu eingerichtet ist, (bei Anordnung zwischen und jeweils im Kontakt zu einer Leiterplatte und einer Blende) die Blende funktionell an die Leiterplatte anzubinden.

Das Bauteil weist ähnlich dem oben beschriebenen Bauteil 20 eine Grundfläche 33 auf, von der eine Überbrückungsstruktur 34 absteht, deren Elastizität in Richtung zur Grundfläche 33 hin durch eine balgartige Auswölbung 36 verstärkt wird. Die Überbrückungsstruktur 34 bildet zudem eine Kammer K₃, die an der einer Leiterplatte zuzuwendenden Seite offen ist, so dass die Überbrückungsstruktur analog zum Obigen über ein Leuchtelement an der Leiterplatte gestülpt werden kann.

Das elektrisch leitfähige Material 32 ist dabei vorliegend als elektrisch leitfähige Silikonschicht ausgebildet. An der ihr entgegengesetzten Seite ist die elastische Silikonschicht 31 mit einem lichtdichten Lack 37 überzogen. Dieser weist im Bereich der der Blende zuzuwendenden Deckfläche 35 vorzugsweise Aussparungen auf, so dass das Bauteil hier zumindest in einem Bereich lichtdurchlässig ist.

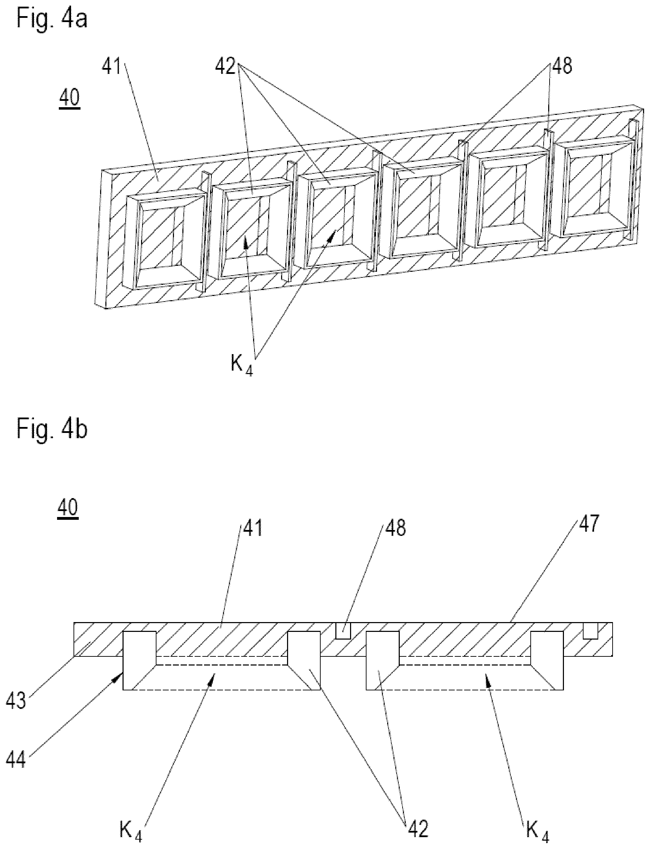

Die Figuren 4a und 4b zeigen ein weiteres Ausführungsbeispiel eines erfindungsgemäßen Bauteils 40, und zwar in einer perspektivischen Ansicht (Figur 4a) und in einer Schnittansicht (Figur 4b).

Das Bauteil 40 umfasst eine elastische Silikonschicht 41, die vorliegend als Platte ausgebildet ist, an der mehrere dreidimensionale Strukturen 42 (von denen in den Figuren aus Gründen der Übersicht nur einige gekennzeichnet sind) jeweils aus elektrisch leitfähigem Material (beispielsweise elektrisch leitfähigem Silikon) angeordnet und eingesenkt sind. Die dreidimensionalen Strukturen 42 sind damit dazu eingerichtet, bei Anordnung des Bauteils 40 zwischen und jeweils im Kontakt zu einer Leiterplatte und einer Blende" die Blende funktionell an die Leiterplatte anzubinden.

Die dreidimensionalen Strukturen 42 bilden dabei in diesem Ausführungsbeispiel jeweils eine rahmenartige Überbrückungsstruktur 44, die von der elastischen Silikonschicht 41 als Grundfläche 43 abstehen. Bei dieser Ausführungsform ist die Grundfläche 43 dazu vorgesehen, an einer Blende anzuliegen, und die dreidimensionalen Strukturen 42 als Überbrückungsstrukturen 43 erstrecken sich dann zur Leiterplatte hin und liegen an ihrem Rand darauf auf.

Die Überbrückungsstrukturen 43 bilden so jeweils eine Kammer K₄ aus, die an der der Leiterplatte zuzuwendenden Seite offen ist. Damit sind sie dazu eingerichtet, über ein jeweiliges Leuchtelement an der Leiterplatte gestülpt zu werden (nicht dargestellt).

Die elastische Silikonschicht 41 ist an ihrer der Blende zuzuwendenden Seite mit einem lichtdichten Lack 47 überzogen. Dieser weist in den Bereichen, die entgegengesetzt zu den Kammern K₄ angeordnet sind, vorzugsweise Aussparungen auf, so dass Licht eines überstülpten Leuchtelements dort durch das Bauteil 40 sowie eine (in Verwendung) daran angeordnete Blende hindurchdringen und so von einem Anwender erfasst werden kann. Vorzugsweise sind die Aussparungen dabei jeweils in Form eines Symbols ausgebildet. Insbesondere sind die Aussparungen an mindestens zweien der Kammern K₄ vorzugsweise voneinander verschieden.

An der den dreidimensionalen Strukturelementen entgegengesetzten Oberfläche des elastischen Silikonschicht und jeweils zu diesen versetzt (also in jeweiligen Zwischenbereichen zwischen je zwei benachbarten dreidimensionalen Strukturelementen 42) sind in der elastischen Silikonschicht 41 Rinnen 48 ausgebildet, in die der lichtdichte Lack 47 ebenfalls eingebracht ist. Dadurch können die lichtdurchlässigen Bereiche jeweils gegen Licht eines benachbarten Lichtelements abgeschottet werden.

Offenbart ist ein Bauelement 10, 20, 30, 40 zur Anordnung zwischen einer Blende 100 und einer Leiterplatte 200 eines kapazitives Bedienelements 1. Das Bauteil umfasst eine elastische Silikonschicht 11, 21, 31, 41 und ein daran angeordnetes elektrisch leitfähiges Material 12, 22, 32, 42, das dazu eingerichtet ist, die Blende 100 des kapazitiven Bedienelements funktionell an dessen Leiterplatte 200 anzubinden.

Offenbart ist weiterhin ein kapazitives Bedienelement mit einer Blende 100, einer Leiterplatte 200 und einem dazwischen in Kontakt zu beiden angeordneten oder anzuordnenden Bauteil 10, 20, 30, 40. Weiterhin offenbart ist ein Haushaltsgerät mit mindestens einem derartigen kapazitiven Bedienelement 1.

### Bezugszeichen

- 1: kapazitives Bedienelement
- 10, 20, 30, 40: Bauelement
- 11, 21, 31, 41: elastische Silikonschicht
- 12, 22, 32, 42: elektrisch leitfähiges Material
- 13, 23, 33, 43: Grundfläche
- 14, 24, 34, 44: Überbrückungsstruktur
- 15, 25, 35: Deckfläche
- 16: ringförmiger Bereich
- 19: Kontaktbereich
- 26, 36: balgartige Auswölbung
- 37, 47: lichtdichter Lack
- 48: Rinne
- K₁, K₂, K₃, K₄: Kammer
- 100: Blende
- 200: Leiterplatte
- 300: Leuchtelement

## Patentansprüche

1. Bauteil (10, 20, 30, 40) für ein eines kapazitives Bedienelement (1), wobei das Bauteil ein elektrisch leitfähiges Material (12, 22, 32, 42) umfasst, das dazu eingerichtet ist eine Blende (100) des kapazitiven Bedienelements funktionell an dessen Leiterplatte (200) anzubinden,
**dadurch gekennzeichnet, dass**
das elektrisch leitfähige Material (12, 22, 32, 42) mindestens teilweise an mindestens einer elastischen Silikonschicht (11, 21, 31, 41) des Bauteils angeordnet ist.

2. Bauteil gemäß Anspruch 1, wobei das elektrisch leitfähige Material
- eine elektrisch leitfähige Farbe (12, 22),
- eine elektrisch leitfähige Silikonschicht (32) und/oder
- ein dreidimensionales Strukturelement (42) aus leitfähigem Material
umfasst.

3. Bauteil gemäß einem der Ansprüche 1 oder 2, das mindestens bereichsweise lichtdurchlässig ist.

4. Bauteil gemäß einem der vorhergehenden Ansprüche, das eine Grundfläche (13, 23, 33, 43) und eine oder mehrere von der Grundfläche abstehende Überbrückungsstruktur/en (14, 24, 34, 44) zur Überbrückung eines Abstandes zwischen der Leiterplatte (200) und der Blende (100) umfasst.

5. Bauteil gemäß Anspruch 4, wobei die Überbrückungsstruktur/en (14, 24, 34, 44) in Richtung zur Grundfläche (13) hin elastisch ist/sind.

6. Bauteil gemäß einem der Ansprüche 4 oder 5, wobei die Überbrückungsstruktur/en jeweils eine an der der Leiterplatte zuzuwendenden Seite offene Kammer (K₁, K₂, K₃, K₄) ausbildet/ ausbilden.

7. Kapazitives Bedienelement (1) mit einer Blende (100), einer Leiterplatte (200) und einem dazwischen in Kontakt zu beiden angeordneten oder anzuordnenden Bauteil (10, 20, 30, 40) gemäß einem der vorhergehenden Ansprüche.

8. Kapazitives Bedienelement nach Anspruch 7, wobei an der Leiterplatte ein oder mehrere Leuchtelement/e (300) angeordnet ist/sind, auf oder über dem/denen sich ein jeweiliger, mindestens teilweise lichtdurchlässiger Bereich des Bauteils erstreckt.

9. Kapazitives Bedienelement nach Anspruch 8, wobei der/die lichtdurchlässige/n Bereich/e in Form eines jeweiligen Symbols ausgebildet ist/sind, das eine funktionelle Bedeutung des kapazitiven Bedienelements im jeweiligen Bereich kennzeichnet.

10. Haushaltsgerät mit einem kapazitiven Bedienelement (1) nach einem der Ansprüche 7 bis 9.
